# EUROPEAN PATENT SPECIFICATION

(11) **EP 3 026 093 B1**
(45) Date of publication and mention of the grant of the patent: **27.09.2017**
(21) Application number: 14195396.8
(22) Date of filing: 28.11.2014
(51) Int. Cl.: C09K 11/06, C08G 61/02, H01L 51/00, H01L 51/50

(54) **Novel materials for the thermal and photochemical solubility switch of conjugated polymers for application in organic electronics**
Neuartige Materialien für Schalter der thermischen und fotochemischen Löslichkeit von konjugierten Polymeren zur Anwendung in der organischen Elektronik
Nouveaux matériaux servant à la commutation de solubilité photochimique et thermique de polymères conjugués pour application en électronique organique

(43) Date of publication of application: 01.06.2016
(73) Proprietor: BASF SE, 67056 Ludwigshafen am Rhein (DE); InnovationLab GmbH, 69115 Heidelberg (DE)
(72) Inventor: Jeltsch, Krischan Fabian, 68161 Mannheim (DE); Schelkle, Korwin Maria, 67056 Ludwigshafen (DE); Hamburger, Manuel, 68199 Mannheim (DE)

(56) References cited:
- EP-A1- 2 315 291
- WO-A1-2012/009344
- US-A1- 2002 106 529
- US-A1- 2005 186 106
- US-A1- 2008 038 572
- US-A1- 2008 074 039
- Esther Scheler ET AL: "Tailoring fluorene-based oligomers for fast photopatterning", Journal of Materials Chemistry, vol. 19, no. 20, 1 January 2009 (2009-01-01), page 3207, XP055186880, ISSN: 0959-9428, DOI: 10.1039/b822894a
- Jin H. Ahn ET AL: "Blue organic light emitting devices with improved colour purity and efficiency through blending of poly(9,9-dioctyl-2,7-fluorene) with an electron transporting material", Journal of Materials Chemistry, vol. 17, no. 29, 1 January 2007 (2007-01-01), page 2996, XP055187068, ISSN: 0959-9428, DOI: 10.1039/b700047b

## Description

The invention relates to polymers having fluorene-diyl groups and specific cinnamate-based groups as well as to the corresponding monomers. The invention further relates to a method for converting said polymers into less soluble ones as well as to the corresponding polymers. The invention further relates to electronic devices comprising said polymers.
Organic light-emitting diodes (OLEDs) have attracted much interest because of their potential low-cost fabrication, energy efficiency and semi-transparency. While physical vapor deposition is still the method of choice for complex multilayer OLED architectures, the evaporation process only works for small molecule compounds. Transferring such evaporation tools to rapid and low-cost reel-to-reel processes is clearly non-trivial. Solution-based approaches bear the potential to circumvent these drawbacks and allow large-area device fabrication. However, they present additional challenges in the preparation of multilayer architectures. One key requirement for these processes is the application of subsequent layers without dissolving previously deposited ones. To meet this requirement, different approaches have been developed, such as the "orthogonal solvent" approach, transformation of soluble precursors after deposition as well as solubility modulation by photo-crosslinking or thermal crosslinking reactions.

E. Scheler et al., J. Mat. Chem., 2009, 19, 3207 recite fluorene-based oligomers having acrylate-functionalised side-chains for photopatterning. EP 2308910 discloses light-emitting devices using polymers having fluorene-diyl groups in the backbone and vinyl-based cross-linkers.
WO 2010/097155 discloses the cross-linking of polymers having aldehyde groups as well as the use of the cross-linked polymers in electronic devices, such as OLEDs.
WO 2005/083812 discloses the cross-linking of oxetane-functionalized, organic semiconductors and conductors initiated by irradiation in the presence of an onium compound.
X.-C. Li et al., Synthetic Metals 1997, 84, 437-438 describes poly(methacrylate) copolymers bearing a UV-sensitive cross-linkable cinnamate unit as well as their application in light-emitting devices.
Y.-D. Zhang et al., J. Mater. Chem. 2002, 12, 1703-1708 describes photo-crosslinkable cinnamate-functionalized methacrylate copolymers as well as their application in organic light-emitting diodes.
The cinnamate groups disclosed in the two last-mentioned publications do not bear an amino group on its phenyl ring.

Apart from the above examples, which relate to the solubility switch via light-induced cross-linking, there are examples in which the solubility switch is effected by light-induced cleavage of solubility imparting moieties. The cleavage of o-nitrobenzyl groups is described in e.g. J. Mater. Chem. 2011, 21, 14041-14047; ACS Macro Lett. 2012, 1, 825-829; Macromol. Chem. phys. 2012, 213, 2443-2449.

The solubility switch can also be effected by thermally induced cleavage of thermally labile esters, which is described in Chem. Mater. 2008, 20, 4386-4390; Macromolecules 2008, 41, 8986-8994.

It is a continuing objective to provide novel materials for the thermal and photochemical solubility switch of conjugated polymers for application in organic electronics which offer advantages over the known compounds.

Accordingly, in one aspect of the invention there is provided a polymer of the formula (I) or (II), 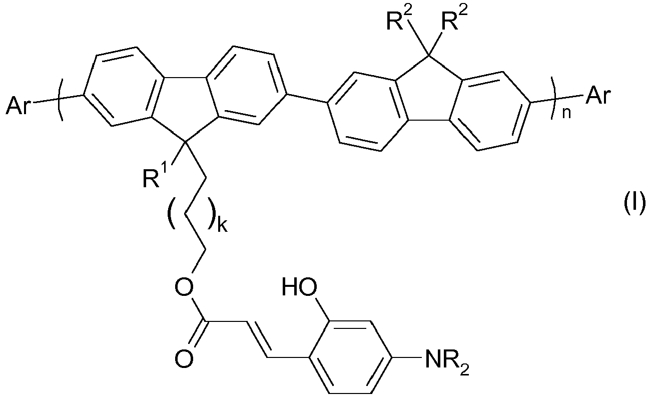 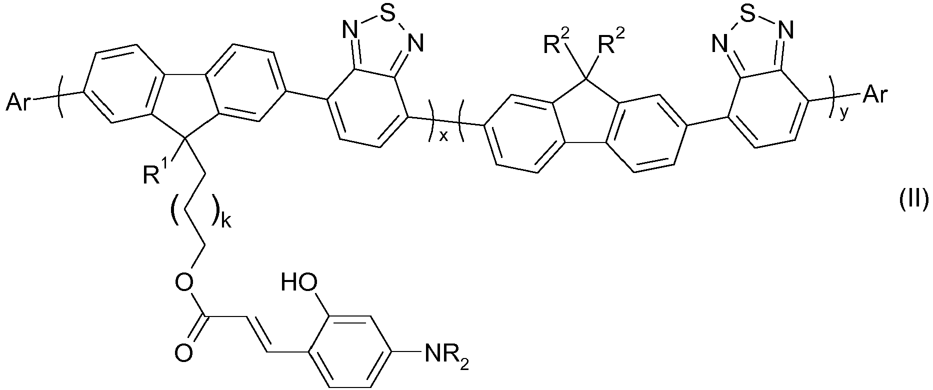 wherein
- each R: is independently a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl; or phenyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃;
- R¹: is a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl;
- each R²: is independently a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl;
- each Ar: is independently phenyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃; biphenyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃; or naphthyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃;
- k: is an integer from 1 to 8;
- n: is an integer from 5 to 1000;
- x: is an integer from 3 to 500;
- y: is an integer from 3 to 500.

The hydroxycinnamic acid motif introduced into the backbones of the polymers can undergo a reaction either by activation with light of a suitable wavelength or by thermal activation, which leads to a reduction of the solubility of the conjugated material. The polymers, which can be processed in the common organic solvents, can thus be directed in their solubility by thermal or light-induced cleavage of the solubility imparting moieties. Therefore films processed from the liquid phase are insoluble after tempering or irradiation. This should allow attractive applications in liquid phase processing.

The present approach allows for spatially resolved structuring. In contrast to other protocols, cinnamates do not require additives such as photoacids, which makes them attractive for a wide range of applications. The optical properties of the amino-substituted cinnamates can easily be tailored to external demands by varying the substituents on the amino group.

The photoreaction produces a coumarin species, which is unproblematic as far as its reactivity is concerned, unlike the very reactive nitroso species. Therefore the coumarin species does not necessarily have to be rinsed out of the film. Furthermore, the connection of the solubility-imparting moiety at the semiconducting material is achieved via a linker, for which reason the barely problematic alcohol remains on the backbone of the polymer after the cleavage. Moreover, no decarboxylation step is necessary.

The present invention provides access to conjugated polymers, which can be directed in their solubility photochemically or thermally. The wavelength required for the solubility switch can be adjusted to the conditions regarding absorption imposed by the conjugated backbone. Furthermore, no additive has to be added to the reaction which might have an adverse effect on the characteristics of the component if it remains in the film. A further advantage is the possibility of displaying the reaction via 2-photon absorption.

Furthermore, the polymers of the present invention can be used as emitting layer in OLEDs. The amino group, in particular a dialkyl amino group, on the cinnamate shifts the absorption beyond 350 nm in order to minimize photochemical degradation upon irradiation. Moreover, the polymers of the present invention can be used to fabricate solution-processed OLEDs. The presence of the amino group on the phenyl ring of the cinnamate increases the solubility of the polymer to which it is attached compared to the solubility of a polymer having a cinnamate-based cross-linker without an amino group on the phenyl ring.

The polymer of the formula (II) can be a block copolymer or a statistical copolymer. In one em bodiment, the polymer of the formula (II) is a block copolymer. In a preferred embodiment, the polymer of the formula (II) is a statistical copolymer.

Preferred are polymers of the formula (I) or (II) wherein each R is independently a linear or branched C₁-C₁₀-alkyl, which is unsubstituted.
More preferred are polymers of the formula (I) or (II) wherein each R is independently a linear or branched C₁-C₆-alkyl, which is unsubstituted.
Even more preferred are polymers of the formula (I) or (II) wherein each R is n-C₄H₉.

Preferred are polymers of the formula (I) or (II) wherein R¹ is a linear or branched C₁-C₁₀-alkyl, which is unsubstituted.
More preferred are polymers of the formula (I) or (II) wherein R¹ is a linear or branched C₁-C₄-alkyl, which is unsubstituted.
Even more preferred are polymers of the formula (I) or (II) wherein R¹ is CH₃.

Preferred are polymers of the formula (I) or (II) wherein each R² is independently a linear or branched C₁-C₁₀-alkyl, which is unsubstituted.
More preferred are polymers of the formula (I) or (II) wherein each R² is independently a linear or branched C₅-C₁₀-alkyl, which is unsubstituted.
Even more preferred are polymers of the formula (I) or (II) wherein each R² is CH₂CH(C₂H₅)(n-C₄H₉).

Preferred are polymers of the formula (I) or (II) wherein each Ar is independently phenyl, which is unsubstituted or substituted with 1 or 2 substituents selected from the group consisting of CN, NO₂, O(C₁-C₄-alkyl), N(C₁-C₄-alkyl)₂, C₁-C₄-alkyl, and CF₃; unsubstituted biphenyl; or unsubstituted naphthyl.
More preferred are polymers of the formula (I) or (II) wherein each Ar is independently phenyl, which is unsubstituted or substituted with 1 or 2 substituents selected from the group consisting of CN, O(C₁-C₄-alkyl), N(C₁-C₄-alkyl)₂, C₁-C₄-alkyl, and CF₃.
Even more preferred are polymers of the formula (I) or (II) wherein each Ar is C₆H₅.

Preferred are polymers of the formula (I) or (II) wherein k is an integer from 1 to 4.
More preferred are polymers of the formula (I) or (II) wherein k is 1 or 2.
Even more preferred are polymers of the formula (I) or (II) wherein k is 1.

Preferred are polymers of the formula (I) wherein n is an integer from 5 to 1000.
More preferred are polymers of the formula (I) wherein n is an integer from 10 to 600.
Even more preferred are polymers of the formula (I) wherein n is an integer from 10 to 400.

Preferred are polymers of the formula (II) wherein x is an integer from 5 to 500.
More preferred are polymers of the formula (II) wherein x is an integer from 5 to 300.
Even more preferred are polymers of the formula (II) wherein x is an integer from 5 to 200.

Preferred are polymers of the formula (II) wherein y is an integer from 5 to 500.
More preferred are polymers of the formula (II) wherein y is an integer from 5 to 300.
Even more preferred are polymers of the formula (II) wherein y is an integer from 5 to 200.

Preferred are polymers of the formula (II) wherein the ratio of x to y is in the range of from 0.7 to 1.5.
More preferred are polymers of the formula (II) wherein the ratio of x to y is in the range of from 0.8 to 1.2.
Even more preferred are polymers of the formula (II) wherein the ratio of x to y is in the range of from 0.9 to 1.1.
Particularly preferred are polymers of the formula (II) wherein the ratio of x to y is 1.0.

Preferred are polymers of the formula (I) or (II) wherein
- each R: is independently a linear or branched C₁-C₁₀-alkyl, which is unsubstituted;
- R¹: is a linear or branched C₁-C₁₀-alkyl, which is unsubstituted;
- each R²: is independently a linear or branched C₁-C₁₀-alkyl, which is unsubstituted;
- each Ar: is independently phenyl, which is unsubstituted or substituted with 1 or 2 substituents selected from the group consisting of CN, NO₂, O(C₁-C₄-alkyl), N(C₁-C₄-alkyl)₂, C₁-C₄-alkyl, and CF₃; unsubstituted biphenyl; or unsubstituted naphthyl;
- k: is an integer from 1 to 4;
- n: is an integer from 10 to 1000;
- x: is an integer from 5 to 500;
- y: is an integer from 5 to 500.

More preferred are polymers of the formula (I) or (II) wherein
- each R: is independently a linear or branched C₁-C₆-alkyl, which is unsubstituted;
- R¹: is a linear or branched C₁-C₄-alkyl, which is unsubstituted;
- each R²: is independently a linear or branched C₅-C₁₀-alkyl, which is unsubstituted;
- each Ar: is independently phenyl, which is unsubstituted or substituted with 1 or 2 substituents selected from the group consisting of CN, O(C₁-C₄-alkyl), N(C₁-C₄-alkyl)₂, C₁-C₄-alkyl, and CF₃;
- k: is 1 or 2;
- n: is an integer from 10 to 600;
- x: is an integer from 5 to 300;
- y: is an integer from 5 to 300.

Even more preferred are polymers of the formula (I) or (II) wherein
- each R: is n-C₄H₉;
- R¹: is CH₃;
- each R²: is CH₂CH(C₂H₅)(n-C₄H₉);
- each Ar: is C₆H₅;
- k: is 1;
- n: is an integer from 10 to 400;
- x: is an integer from 5 to 200;
- y: is an integer from 5 to 200.

In one embodiment the polymer of the invention is a polymer of the formula (I).

In another embodiment the polymer of the invention is a polymer of the formula (II).

The polymer of the formula (I) or (II) preferably has a number average molecular weight (Mₙ) in the range of from 2 to 100 kg/mol, more preferably 3 to 50 kg/mol, even more preferably 5 to 30 kg/mol.

The polymer of the formula (I) or (II) preferably has a weight average molecular weight (M_{w}) in the range of from 2 to 100 kg/mol, more preferably 3 to 50 kg/mol, even more preferably 5 to 30 kg/mol.

The polymer of the formula (I) or (II) preferably has a polydispersity index (PDI) in the range of from 1 to 5, more preferably 1.5 to 4, even more preferably 1.7 to 3.

Number average molecular weights (Mₙ), weight average molecular weights (M_{w}), and polydispersity indexes (PDI) were determined by gel permeation chromatography (GPC) as described further below.

In a further aspect of the invention there is provided a method for converting a polymer of the formula (I) or (II) as defined herein into a polymer which is less soluble than the polymer of the formula (I) or (II), comprising the following steps:
(i) providing a polymer of the formula (I) or (II) as defined herein;
(ii) irradiating the polymer of step (i) with light of a wavelength in the range of from 320 to 420 nm or subjecting the polymer of step (i) to temperatures in the range of from 120 to 300 °C to obtain a polymer which is less soluble than the polymer of the formula (I) or (II).

In one embodiment the polymer in step (ii) is irradiated with light of a wavelength in the range of from 350 to 380 nm.

In another embodiment the polymer in step (ii) is subjected to temperatures in the range of from 180 to 220 °C.

In one embodiment the method further comprises the following step:
(iii) removing polymers which were not converted into less soluble polymers by rinsing with one or more solvents.

Examples of solvents that can be used in step (iii) are THF, toluene, or chloroform.

In a further aspect of the invention there is provided a polymer obtainable by the method described herein.

Preferred, more preferred, even more preferred and particularly preferred polymers are the ones obtainable from the respective preferred, more preferred, even more preferred and particularly preferred polymers of the formula (I) or (II).

In a further aspect of the invention there is provided a monomer of the formula (III), 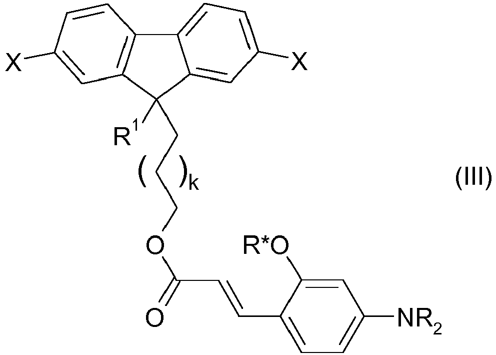 wherein
- each X: is independently halogen or OS(O)₂CF₃;
- each R: is independently a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl; or phenyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃;
- R¹: is a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl;
- R*: is H, tri(C₁-C₆-alkyl)silyl, or (C₁-C₆-alkyl)diphenylsilyl;
- k: is an integer from 1 to 8.

The C₁-C₆-alkyl groups in the tri(C₁-C₆-alkyl)silyl group can be linear or branched.

The C₁-C₆-alkyl groups in the tri(C₁-C₆-alkyl)silyl group can be identical or different.

The C₁-C₆-alkyl group in the (C₁-C₆-alkyl)diphenylsilyl group can be linear or branched.

Preferred are monomers of the formula (III) wherein each X is independently Cl, Br, I, or OS(O)₂CF₃.
More preferred are monomers of the formula (III) wherein each X is independently Br, I, or OS(O)₂CF₃.
Even more preferred are monomers of the formula (III) wherein each X is Br.

Preferred are monomers of the formula (III) wherein R* is tri(C₁-C₆-alkyl)silyl or (C₁-C₆-alkyl)diphenylsilyl.
More preferred are monomers of the formula (III) wherein R* is tri(C₁-C₆-alkyl)silyl.
Even more preferred are monomers of the formula (III) wherein R* is tert-butyldimethylsilyl.

Preference is also given to monomers of the formula (III) wherein R* is trimethylsilyl, triethylsilyl, triisopropyl, tert-butyldimethylsilyl, or tert-butyldiphenylsilyl.

Particular preference is also given to monomers of the formula (III) wherein R* is trimethylsilyl, triethylsilyl, triisopropyl, or tert-butyldimethylsilyl.

In one embodiment, R* is H.

Preferred, more preferred, even more preferred and particularly preferred monomers of the formula (III) are the ones leading to the respective preferred, more preferred, even more preferred and particularly preferred polymers of the formula (I) or (II).

Preferred are monomers of the formula (III) wherein
- each X: is independently Cl, Br, I, or OS(O)₂CF₃;
- each R: is independently a linear or branched C₁-C₁₀-alkyl, which is unsubstituted;
- R¹: is a linear or branched C₁-C₁₀-alkyl, which is unsubstituted;
- R*: is tri(C₁-C₆-alkyl)silyl or (C₁-C₆-alkyl)diphenylsilyl;
- k: is an integer from 1 to 4.

More preferred are monomers of the formula (III) wherein
- each X: is independently Br, I, or OS(O)₂CF₃;
- each R: is independently a linear or branched C₁-C₆-alkyl, which is unsubstituted;
- R¹: is a linear or branched C₁-C₄-alkyl, which is unsubstituted;
- R*: is tri(C₁-C₆-alkyl)silyl;
- k: is 1 or 2.

Even more preferred are monomers of the formula (III) wherein
- each X: is Br;
- each R: is n-C₄H₉;
- R¹: is CH₃;
- R*: is tert-butyldimethylsilyl;
- k: is 1.

In a further aspect of the invention there is provided an electronic device comprising the polymer described herein.

In one embodiment the electronic device is an organic light-emitting diode (OLED).

Polymers of the formula (I) or (II) can, for example, be prepared by Suzuki polymerization. Suitable reaction conditions are known to a person skilled in the art and can also be found in e.g. M. Ranger, D. Rondeau, M. Leclerc, Macromolecules 1997, 30, 7686-7691.

The Suzuki polymerization can, for example, be carried out in the presence of a suitable catalyst, in the presence of a suitable base, in the presence of a suitable solvent, and optionally in the presence of suitable additives.

An example of a suitable catalyst for the Suzuki polymerization is Pd(PPh₃)₄.

Examples of suitable bases for the Suzuki polymerization are Na₂CO₃, K₂CO₃, or Cs₂CO₃,

Examples of suitable solvents for the Suzuki polymerization are THF, water, or THF/water mixtures.

Examples of suitable additives for the Suzuki polymerization are phase transfer catalysts. An example of a suitable phase transfer catalyst is aliquat 336.

The Suzuki polymerization can, for example, be carried out at temperatures in the range of from 40 to 100 °C, preferably 50 to 80°C.

After the Suzuki polymerization has been carried out to the desired degree, the Ar end groups can, for example, be introduced by adding an aryl boronic acid, ArB(OH)₂, optionally together with fresh catalyst, then stirring for some time, then adding an aryl bromide, ArBr, optionally together with fresh catalyst, and then again stirring for some time.

In a preferred embodiment, where a siloxy group is present on the monomer of the formula (III) used in the Suzuki polymerization, the siloxy group can be converted into a hydroxyl group, preferably after the Suzuki polymerization has been carried to the desired degree and preferably after the Ar end groups have been introduced. Said siloxy group can, for example, be converted into said hydroxyl group by treatment with a suitable fluoride source such as tetrabutylammonium fluoride (TBAF), preferably in the presence of a suitable solvent such as THF.

Polymers of the formula (I) can, for example, be prepared from monomers of the formula (III) as defined herein and from monomers of the formula (IV): 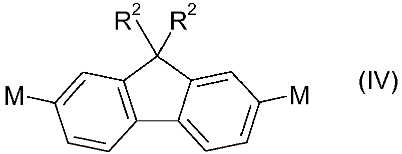 wherein R² is as defined in the respective polymer of the formula (I), and wherein M is a boronic acid group or a suitable boronic ester group.

Preference is given to monomers of the formula (IV) wherein M is B(OH)₂ or B[OC(CH₃)₂C(CH₃)₂O].
Particular preference is given to monomers of the formula (IV) wherein M is B[OC(CH₃)₂C(CH₃)₂O].

Accordingly, particularly preferred monomers of the formula (IV) are monomers of the formula (IVa):

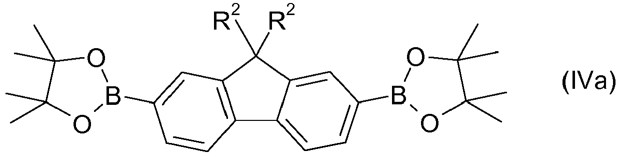

Preferred, more preferred, even more preferred and particularly preferred monomers of the formula (IV) are the ones leading to the respective preferred, more preferred, even more preferred and particularly preferred polymers of the formula (I).

Polymers of the formula (II) can, for example, be prepared from monomers of the formula (III) as defined herein, from monomers of the formula (V), and from monomers of the formula (VI).

Monomers of the formula (V): 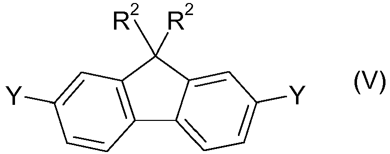 wherein R² is as defined in the respective polymer of the formula (II), and wherein Y is halogen or OS(O)₂CF₃.

Preference is given to monomers of the formula (V) wherein Y is Cl, Br, I, or OS(O)₂CF₃. Particular preference is given to monomers of the formula (V) wherein Y is Br, I, or OS(O)₂CF₃. Very particular preference is given to monomers of the formula (V) wherein Y is Br.

Preferred, more preferred, even more preferred and particularly preferred monomers of the formula (V) are the ones leading to the respective preferred, more preferred, even more preferred and particularly preferred polymers of the formula (II).

Monomers of the formula (VI): 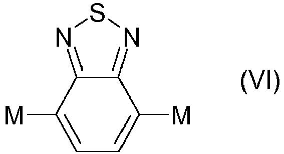 wherein M is a boronic acid group or a suitable boronic ester group.

Preference is given to monomers of the formula (VI) wherein M is B(OH)₂ or B[OC(CH₃)₂C(CH₃)₂O].
Particular preference is given to monomers of the formula (VI) wherein M is B[OC(CH₃)₂C(CH₃)₂O].

Accordingly, particularly preferred monomers of the formula (VI) are monomers of the formula (VIa):

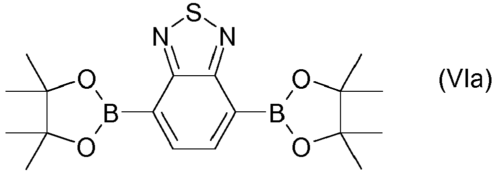

Preferred, more preferred, even more preferred and particularly preferred monomers of the formula (VI) are the ones leading to the respective preferred, more preferred, even more preferred and particularly preferred polymers of the formula (II).

A representative procedure for the preparation of a specific example of a polymer of the formula (I) is given in Scheme A:

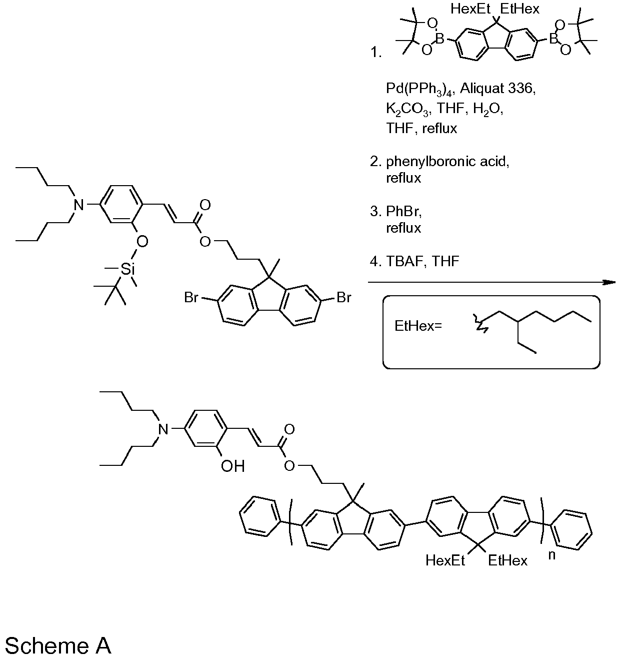

A representative procedure for the preparation of a specific example of a polymer of the formula (II) is given in Scheme B:

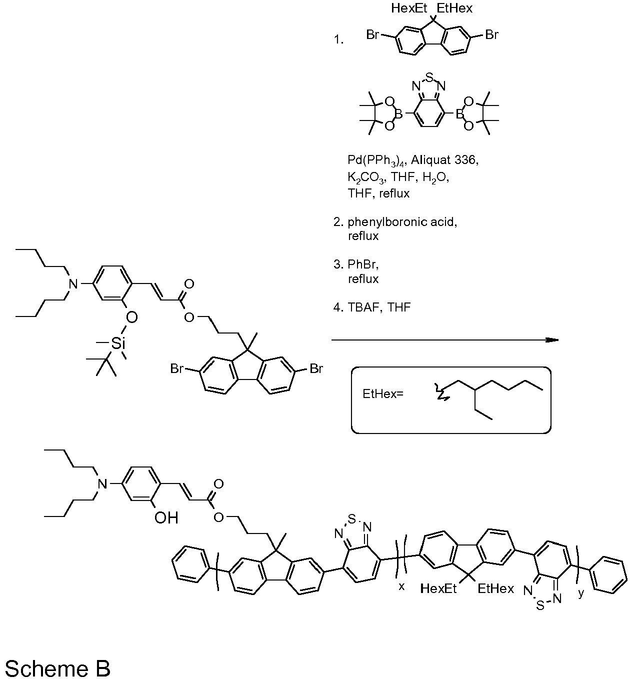

The monomers of the formulae (III), (IV), (V), and (VI) are either commercially available or they can be prepared by methods known to a person skilled in the art, see e.g. M. Ranger, D. Rondeau, M. Leclerc, Macromolecules 1997, 30, 7686-7691.

A representative sequence for the preparation of a specific example of a monomer of the formula (III) is given in Scheme C:

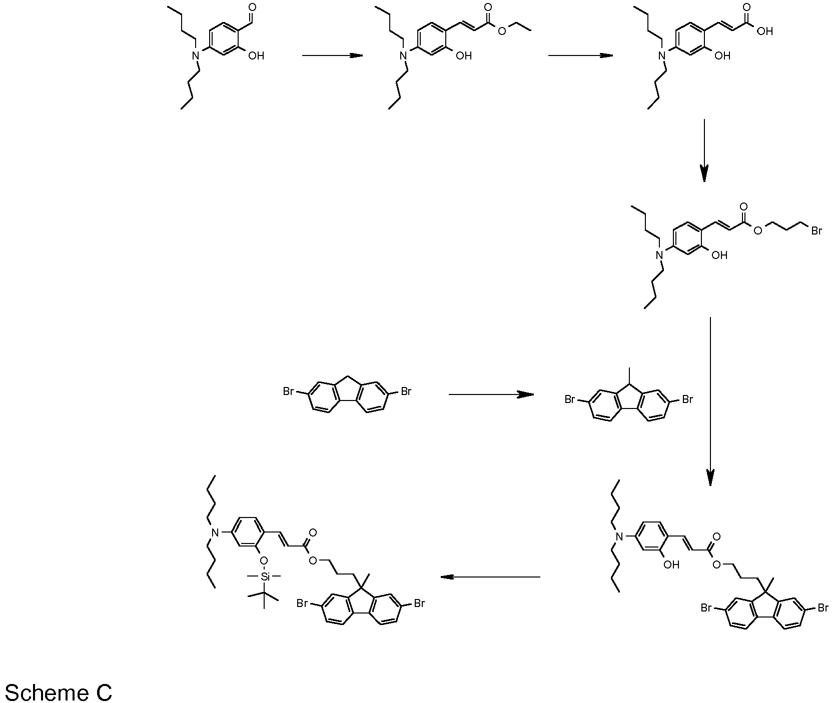

Representative procedures for the preparation of a specific example of a monomer of the formula (III) are given further below.

A person skilled in the art knows how to modify the sequence given in Scheme C and the procedures given further below in order to obtain other monomers of the formula (III).

The invention is illustrated by the following examples without being limited thereby.

### Examples

### General remarks:

All reactions requiring exclusion of oxygen and moisture were carried out in dry glassware under a dry and oxygen free argon or nitrogen atmosphere. For spectroscopic and analytic characterizations the following devices were available:

### Analytical thin layer chromatography (TLC):

TLC was performed on Macherey-Nagel Polygram^{®} SIL G/UV₂₅₄ precoated sheets. Components were visualized by observation under UV irradiation (254 nm and 365 nm) or with aqueous KMnO₄ solution (1.5 g KMnO₄, 25 g Na₂CO₃, 250 mL H₂O).

### Flash column chromatography:

Flash column chromatography was carried out on silica gel (0.032 mm-0.062 mm), purchased from Macherey, Nagel & Co.

### Nuclear magnetic resonance (NMR):

¹H NMR, ¹³C-NMR and spectra were recorded at room temperature on Bruker Avance DRX 300 (300 MHz), Bruker Avance III 300 (300 MHz), Bruker Avance III 400 (400 MHz), Bruker Avance III 500 (500 MHz) and Bruker Avance III 600 (600 MHz). Chemical shifts (δ) are reported in parts per million (ppm) relative to residual un-deuterated solvent peak, coupling constants in Hz. The following abbreviations are used to indicate the signal multiplicity: s (singlet), d (doublet), t (triplet), q (quartet), m (multiplet), dd (doublet of doublet). All NMR spectra were integrated and processed using Topspin 3.2 software.

### High resolution mass spectrometry (HR-MS):

High resolution mass spectra were determined at the Organisch-Chemisches Institut of the University of Heidelberg under the direction of Dr. J. Gross. All methods were recorded on a Vacuum Generator ZAB-2F (EI⁺), Finnigan MAT TSQ 700 (ESI⁺), JEOL JMS-700 (FAB⁺) spectrometer.

### Absorption spectrometry:

Absorption spectra were recorded on a Jasco UV-VIS V-660 or Jasco UV-VIS V-670 in solution or in solid state via a spin-coated glass-slide.

### Emission spectroscopy:

Emission spectra were recorded on a Jasco FP-6500 in solution or in solid state via a spin-coated glass-slide.

### Gel permeation chromatography:

Gel permeation chromatography was performed with Jasco intelligent RI- and UV/Vis-detectors (RI-2031Plus, UV-2075Plus). Number- (Mn) and weight average (Mw) molecular weights and polydispersities (PDI) were determined by GPC versus polystyrene standards. Measurements were carried out at room temperature in chloroform (flow rate 1 mL/min) with PSS-SDV columns (8.0 mm x 30.0 mm, 5 µm particles, 102-, 103- and 105- Å pore size). All GPC-spectra were analyzed and processed by PSS WinGPC Unity Build 9350.

### HPLC/MS analysis:

HPLC/MS analysis was carried out on a Waters BEH C8 (2.1 x 50 mm); elution was performed at a flow rate of 1 ml/min with a linear gradient of acetonitrile in 0.1 % formic acid in water from 50 to 100 % (v/v) over 7 min.

### Solvents:

Solvents were purchased from the store of the Theoretikum or chemical store at the Organisch-Chemisches Institut of the University of Heidelberg and if necessary distilled prior use. All of the other absolute solvents were dried by a MB SPS-800 using drying columns.

### Chemicals:

Chemicals were either purchased from the chemical store at the Organisch-Chemisches Institut of the University of Heidelberg or from commercial laboratory suppliers. Reagents were used without further purification unless otherwise noted.

### Synthesis examples

### (E)-ethyl 3-(4-(dibutylamino)-2-hydroxyphenyl)acrylate:

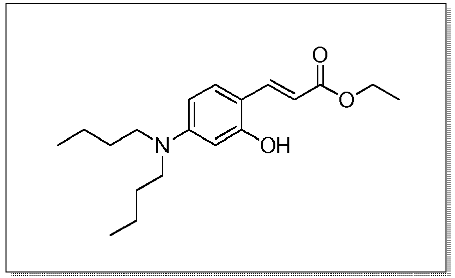

In an oven dried Schlenk flask 4-(dibutylamino)-2-hydroxybenzaldehyde (0.82 g, 3.30 mmol, 1.00 equiv) and carboethoxymethylidentriphenyl-phosphorane (1.74 g, 5.00 mmol, 1.50 equiv) were dissolved in dry toluene (35.0 ml). The reaction mixture was stirred at 60°C under argon for 12 hours upon protection from light. After cooling to room temperature all solvent was removed under reduced pressure and the crude product was purified via column chromatography on silica petroleum ether/ethyl acetate (10/1) to afford 0.98 g of the title compound as yellow solid (93% yield).
NMR spectroscopy: ¹H-NMR (300 MHz, CDCl₃, δ): 7.92 (d, *J =* 16.0 Hz, 1 H), 7.30 (br. s, 1 H), 7.20 (d, *J =* 8.8 Hz, 1 H), 6.33 (d, *J =* 16.0 Hz, 1 H), 6.11 (dd, *J =* 8.8, 1.9 Hz, 1 H), 6.02 (d, *J =* 2.0 Hz, 1 H), 4.17 (q, *J =* 7.2 Hz, 2 H), 3.23 - 3.07 (m, 4 H), 1.52 - 1.42 (m, 4 H), 1.30 - 1.18 (m, 7 H), 0.91 - 0.78 (m, 6H). ¹³C-NMR (75MHz, CHCl₃, δ): 169.76, 157.75, 151.15, 141.68, 130.59, 111.10, 109.58, 104.70, 98.13, 60.11, 50.67, 29.44, 20.21, 14.37, 13.88.
HRMS (FAB+) calcd for C₁₉H₃₀ NO₃ [M+H⁺] 320.2226 found 320.2221

### (E)-3-(4-(dibutylamino)-2-hydroxyphenyl)acrylic acid:

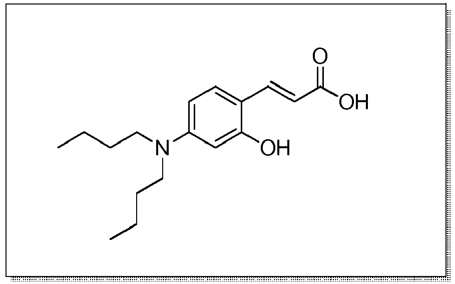

In an oven dried Schlenk flask (E)-ethyl 3-(4-(dibutylamino)-2-hydroxyphenyl)acrylate (6.39 g, 20.0 mmol, 1.00 equiv) was dissolved in ethanol (40.0 ml) and an aqueous of 10 wt% LiOH (60.0 ml) was added. The reaction mixture was stirred at 40°C under argon for 24 hours. EtOAc (150.0 ml) was added and the reaction mixture was acidified using 2M HCl until the organic phase turns yellow. The organic layer was separated while the aqueous phase was washed for several times with EtOAC. The combined organic layers were washed with brine and dried over Na₂SO₄. All organic solvent was then removed under reduced pressure to afford 5.10 g of the title compound as yellow solid (88% yield).
NMR spectroscopy: ¹H-NMR (300 MHz, DMSO-*d₆*, δ): 10.93 (br. s, 1 H), 9.03 (br. s, 1 H), 6.98 (d, *J =* 16.0 Hz, 1 H), 6.58 (d, *J =* 8.5 Hz, 1 H), 5.57 - 5.09 (m, 3 H), 0.87 - 0.68 (m, 5 H), 0.65 - 0.45 (m, 5 H), 0.18 (t, *J =* 7.0 Hz, 6 H). ¹³C-NMR (75 MHz, DMSO-*d₆*, δ): 168.86, 158.35, 150.66, 140.44, 130.02, 111.12, 108.79, 103.95, 97.52, 29.13, 19.69, 13.85.
HRMS (FAB+) calcd for C₁₇H₂₆NO₃ [M+H⁺] 292.1907 found 292.1911

### (E)-3-bromopropyl 3-(4-(dibutylamino)-2-hydroxyphenyl)acrylate:

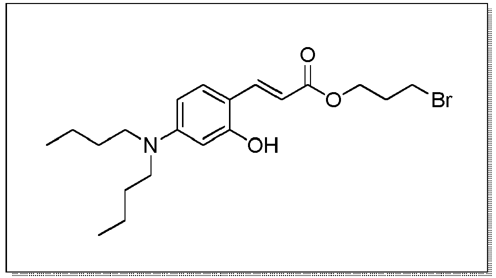

In an oven dried Schlenk flask (E)-3-(4-(dibutylamino)-2-hydroxyphenyl)acrylic acid (1.45 g, 5.00 mmol, 1.00 equiv) was dissolved in dry DMF (25.0 ml). 1,3-dibromopropane (0.77 ml, 7.50 mmol, 1.50 equiv) was added and the reaction mixture was stirred vigorously. Potassium-bicarbonate (0.75 g, 7.50 mmol, 1.50 equiv) was added in one portion and the turbid mixture was stirred at 50°C under argon for 18 hours. After cooling to ambient temperature the solids were collected by filtration and washed with EtOAc (100 ml). Water was added to the filtrate and the organic layer was separated while the aqueous layer was washed for several times with EtOAc. The combined organic layers were washed with brine, dried over Na₂SO₄ and concentrated under reduced pressure. The crude product was purified via column chromatography on silica using mixtures of petroleum ether and ethyl acetate to afford 1.25 g of the title compound as yellow solid (61 % yield).
NMR spectroscopy: ¹H-NMR (300 MHz, CDCl₃, δ): 7.97 (d, *J =* 16.0 Hz, 1 H), 7.30 (d, *J =* 8.8 Hz, 1 H), 6.38 (d, *J =* 16.0 Hz, 1 H), 6.22 (dd, *J =* 8.80, 2.4 Hz, 1 H), 6.76 (br. s, 1 H), 6.07 (d, *J =* 2.4Hz, 1 H), 4.34 (t, *J =* 6.0 Hz, 2 H), 3.53 (t, *J =* 6.60 Hz, 2 H), 3.33-3.18 (m, 4 H), 2.31 - 2.20 (m, 2 H), 1.66 - 1.47 (m, 4 H) 1.44 - 1.23 (m, *J* = 14.91, 7.36 Hz, 4 H), 0.96 (t, *J* = 7.3 Hz, 6 H). ¹³C-NMR (75 MHz, CHCl₃, δ): 169.25, 157.47, 151.24, 141.77, 130.72, 110.77, 109.39, 104.97, 98.06, 61.82, 50.71, 32.01, 29.73, 29.44, 20.25, 13.93.
HRMS (El+) calcd for C₂₀H₃₀BrNO₃ [M+] 411.1409 found 411.1407

### (E)-3-(2,7-dibromo-9-methyl-9H-fluoren-9-yl)propyl3-(4-(dibutylamino)-2-hydroxyphenyl)acrylate:

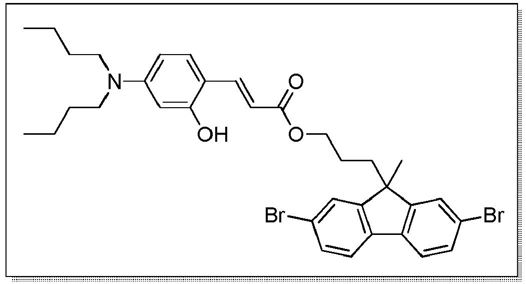

In an oven dried Schlenk flask 2,7-dibromo-9H-flourene (1.00 g, 3.00 mmol, 1.00 equiv) was dissolved in anhydrous THF (10.0 ml) and NaH (0.43 g, 18.0 mmol, 6.00 equiv) was added in portions. After stirring for 30 minutes at room temperature (E)-3-bromopropyl 3-(4-(dibutylamino)-2-hydroxyphenyl)acrylate (1.36 g, 3.00 mmol, 1.10 equiv) dissolved in anhydrous THF (10.0 mol) was added dropwise under vigorous stirring. The reaction mixture was stirred for 6 hours at room temperature before quenching by careful addition of sat. NH₄Cl solution (5.00 ml). EtOAC (50.0 ml) was added to the mixture and the organic layer was separated while the aqueous layer was washed several times with EtOAc. The combined organic layers were washed with brine, dried over Na₂SO₄ and concentrated under reduced pressure. The crude product was purified via column chromatography on silica (petroleum ether/ethyl acetate 5/1) to afford 1.60 g of the title compound as yellowish solid (80% yield).
NMR spectroscopy: ¹H-NMR (600 MHz, CDCl₃, δ): 7.88 (d, *J =* 16.0 Hz, 1 H), 7.56-7.45 (m, 6 H), 7.31 (d, *J =* 8.8 Hz, 1 H), 6.29 (d, *J =* 16.0 Hz, 1 H), 6.22 (dd, *J =* 8.8 Hz, 2.2 Hz, 1 H), 6.02 (br. s, 1H), 6.00 (d, *J =* 2.2 Hz, 2 H), 3.95 (t, *J =* 6.6 Hz, 2 H), 3.33 - 3.21 (m, 4 H), 2.05 - 2.14 (m, 2 H), 1.61 - 1.53 (m, 4 H), 1.49 - 1.47 (m, 3 H), 1.38 - 1.31 (m, 4H), 1.08 - 0.99 (m, 2 H), 0.96 (t, *J =* 7.3 Hz, 6 H). ¹³C-NMR (150 MHz, CHCl₃, δ): 168.85, 156.99, 153.18, 151.05, 140.85, 138.10, 130.60, 130.50, 126.19, 121.65, 121.39, 111.42, 109.34, 105.06, 98.00, 63.75, 50.91, 50.72, 36.54, 29.42, 26.58, 23.80, 20.26, 13.96.
HRMS (FAB+) calcd for C₃₄H₃₉Br₂NO₃ [M+] 667.1297 found 667.1297

### (E)-3-(2,7-dibromo-9-methyl-9H-fluoren-9-yl)propyl3-(2-((tert-butyldimethylsilyl)oxy)-4-(dibutylamino)phenyl)acrylate:

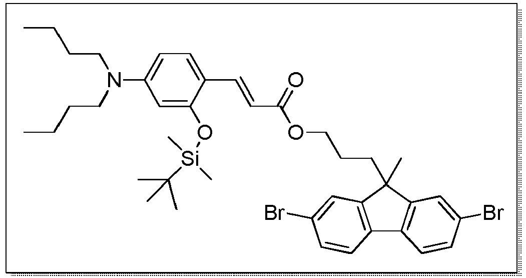

In an oven dried Schlenk flask (E)-3-(2,7-dibromo-9-methyl-9H-fluoren-9-yl)propyl-3-(4-(dibutylamino)-2-hydroxyphenyl)acrylate (1.00 g, 1.50 mmol, 1.00 equiv) and imidazole 0.23 g, 3.30 mmol, 2.20 equiv) were dissolved in anhydrous DCM (3.00 ml) and the solution was cooled to 0°C. *Tert-*butyldimethylsilylchloride (0.27 g, 1.80 mmol, 1.20 equiv) was added and the reaction mixture was allowed to warm to room temperature. After 24 hours the reaction mixture was filtered and water (5.00 ml) was added to the filtrate. The filtrate was extracted with DCM and the combined organic layers were washed with brine, dried over Na₂SO₄ and concentrated under reduced pressure. The crude product was purified via column chromatography on silica (petroleum ether/ethyl acetate 7/1) to afford 1.00 g of the title compound as yellow oil (90% yield).
NMR spectroscopy: ¹H-NMR (400 MHz, CDCl₃, δ): 7.93 (d, *J =* 16.0 Hz, 1 H), 7.55-7.46 (m, 6H), 7.39 (d, *J =* 8.8 Hz, 1 H), 6.27 (dd, *J* = 8.8 Hz, 2.2 Hz, 1 H), 6.10 (d, *J =* 16.0 Hz, 1 H), 6.02 (d, *J =* 2.2 Hz, 1 H), 3.94 (t, *J =* 6.7 Hz, 2 H), 3.16 - 3.32 (m, 4 H), 2.00 - 2.12 (m, 2 H), 1.63 - 1.53 (m, 4 H), 1.48 (s, 3 H), 1.44 - 1.27 (m, 6 H), 1.09 - 0.87 (m, 15 H), 0.23 (s, 6 H). ¹³C-NMR (100 MHz, CHCl₃, δ): 168.0, 156.40, 153.28, 150.95, 140.45, 138.13, 130.55, 128.54, 126.25, 121.68, 121.38, 113.22, 110.94, 105.82, 101.98, 63.59, 50.94, 50.92, 36.57, 29.51, 26.53, 25.80, 23.93, 20.31, 18.46, 13.93. -4.20.
HRMS (FAB+) calcd for C₄₀H₅₃Br₂NO₃Si [M+] 781.2161 found 781.2161

### 2,7-dibromo-9H-flourene:

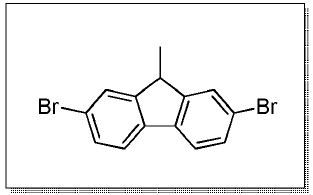

2,7-dibromo-9-methyl-9H-fluorene was prepared as described in WO11091086, example 3b.
NMR spectroscopy: ¹H-NMR (300 MHz, CDCl₃, δ): 7.63 (s, 2 H), 7.58 (d, *J* = 8.1 Hz, 2 H), 7.50 (d, *J* = 8.1 Hz, 2 H), 3.93 (q, *J* = 7.2 Hz, 1 H), 1.51 (d, *J* = 7.2 Hz, 3 H). ¹³C-NMR (75 MHz, CHCl₃, δ): 150.6, 138.5, 135.7, 130.3, 127.5, 121.2, 42.4, 17.9.
HRMS (El+) calcd for C₁₄H₁₁Br₂ [M+H+] 336.9149 found 336.9053.

### 7-(dibutyl)-2H-chromen-2-one:

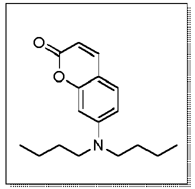

In an oven dried Schlenk flask 4-(dibutylamino)-2-hydroxybenzaldehyde (1.00 g, 4.00 mmol, 1.00 equiv) was dissolved in dry ethanol and dimethyl malonate (0.92 ml, 8.00 mmol, 2.00 equiv) was added followed by dry pyridine (0.39 ml, 4.80 mmol, 1.20 equiv). The reaction mixture was refluxed until no more gas evolution is observed. After cooling to room temperature the solvent was removed under reduced pressure and the obtained residue was dissolved in hydrochloric acid (20.0 ml, 37%) and glacial acetic acid (20.0 ml) and refluxed for 6 hours. The mixture was cooled to room temperature and water (50.0 ml) was added. Aqueous sodium hydroxide solution (40%) was added dropwise until pH = 5. The mixture was stirred for 1 hour and the precipitate was filtered off. The crude product was purified via column chromatography on silica (petroleum ether/ethyl acetate 4/1) to afford 0.90 g of the title compound as colorless solid (82% yield).
NMR spectroscopy: ¹H-NMR (300 MHz, CDCl₃, δ): 7.50 (d, *J* = 9.1 Hz, 1 H), 7.19 (d, *J* = 8.3 Hz, 1 H), 6.50 (dd, *J* = 8.3, 2.6 Hz, 1 H), 6.42 (d, *J* = 2.6 Hz, 1 H), 5.98 (d, *J* = 9.1 Hz, 1 H), 3.28 (t, *J* = 3.3 Hz, 4 H), 1.61 - 1.51 (m, 4 H), 1.40 - 1.27 (m, 4 H), 0.93 (t, *J* = 7.4 Hz, 6 H) ¹³C-NMR (75 MHz, CHCl₃, δ): 162.3, 156.7, 151.1, 143.7, 128.7, 109.0, 108.7, 108.2, 97.6, 51.0, 29.2, 20.2, 13.9.
HRMS (EI+) calcd for C₁₄H₁₁Br₂ [M+H⁺] 336.9149 found 336.9053.

### Polymerisation examples

### Polymerisation A:

(E)-3-(2,7-dibromo-9-methyl-9H-fluoren-9-yl)propyl3-(2-((tert-butyldimethylsilyl)oxy)-4-(dibutylamino)phenyl)acrylate (0.25 g, 0.32 mmol, 1.00 equiv), 2,2'-(9,9-bis(2-ethylhexyl)-9H-fluorene-2,7-diyl)bis(4,4,5,5-tetramethyl-1,3,2-dioxaborolane) (0.21 g, 0.32 mmol, 1.00 equiv) were dissolved in THF (10.0 ml) and 2M K₂CO₃(2.00 ml) was added along with alliquat 336. The resulting mixture was flushed with argon for 30 minutes then Pd(PPh₃)₄ (0.02 g, 0.02 mmol, 0.05 equiv) was added and the reaction tube was sealed. The mixture was then heated to 65°C under vigorous steering. After 72 hours phenylboronic acid (0.04 g, 0.32 mmol, 1.00 eqiuv) was added along with fresh catalyst. The reaction mixture was stirred for 12 hours until bromobenzene (0.04 ml, 0.32 mmol, 1.00 equiv) was added and the reaction was stirred for another 12 hours. Then the reaction was cooled to ambient temperature and precipitated by pouring onto MeOH (200 ml). The precipitate was filtered off and redissolved in little CHCl₃. The obtained solution was added dropwise into a solution of MeOH (100 ml) and the precipitate was collected by filtration. After drying *in vacuo* for one day the polymer was dissolved in THF (40.0 ml) and TBAF as 1M solution in THF (0.4 ml, 0.4 mmol) was added dropwise under stirring. After 1 hour sat. NH₄Cl-solution (10.0 ml) was added, the organic layer was separated and washed several times with brine (3 x 10.0 ml). The organic layer was then dried over Na₂SO₄ and concentrated under reduced pressure. The crude product was purified by preparative GPC using CHCl₃ as eluent to afford 0.10 g of the desired polymer (24% yield).
NMR spectroscopy: ¹H-NMR (600 MHz, CDCl₃, δ): 8.00 - 7.35 (m), 6.45 - 5.90 (m), 4.24 - 3.90 (m), 3.45 br. s), 3.22 (br. s), 2.16 (br. s), 1.72 - 1.47 (m), 1.40 - 1.16 (m), 1.05 - 0.77 (m), 0.78 - 0.53 (m).
GPC Mn = 11.1 kg/mol, Mw = 22.2 kg/mol, PDI = 2.00

### Polymerisation B:

(E)-3-(2,7-dibromo-9-methyl-9H-fluoren-9-yl)propyl3-(2-((tert-butyldimethylsilyl)oxy)-4-(dibutylamino)phenyl)acrylate (0.39 g, 0.50 mmol, 1.00 equiv), 2,7-dibromo-9,9-bis(2-ethylhexyl)-9H-fluorene (0.27 g, 0.50 mmol, 1.00 equiv) and 4,7-bis(4,4,5,5-tetramethyl-1,3,2-dioxaborolan-2-yl)benzo[c][1,2,5]thiadiazole (0.39 g, 1.00 mmol, 2.00 equiv) were dissolved in THF (15.0 ml) and 2M K₂CO₃ (2.50 ml) was added along with alliquat 336. The resulting mixture was flushed with argon for 30 minutes then Pd(PPh₃)₄ (0.06 g, 0.05 mmol, 0.10 equiv) was added and the reaction tube was sealed. The mixture was then heated to 65°C under vigorous steering. After 72 hours phenylboronic acid (0.12 g, 1.00 mmol, 2.00 eqiuv) was added along with fresh catalyst. The reaction mixture was stirred for 12 hours until bromobenzene (0.10 ml, 1.00 mmol, 2.00 equiv) was added and the reaction was stirred for another 12 hours. Then the reaction was cooled to ambient temperature and precipitated by pouring onto MeOH (200 ml).

The precipitate was filtered off and redissolved in little CHCl₃. The obtained solution was added dropwise into a solution of MeOH (100 ml) and the precipitate was collected by filtration. After drying *in vacuo* for one day the polymer was dissolved in THF (50.0 ml) and TBAF as 1M solution in THF (0.50 ml, 0.50 mmol) was added dropwise under stirring. After 1 hour sat. NH₄Cl-solution (10.0 ml) was added, the organic layer was separated and washed several times with brine (3 x 10.0 ml). The organic layer was then dried over Na₂SO₄ and concentrated under reduced pressure. The crude product was purified by preparative GPC using CHCl₃ as eluent to afford 0.05 g of the desired polymer (10% yield).
NMR spectroscopy: ¹H-NMR (600 MHz, CDCl₃, δ): 8.15 - 7.78 (m), 7.75 - 7.34 (m), 6.32 - 6.00 (m), 4.00 (br. s.), 3.40 (br. s), 3.29 - 3.07 (m), 2.40 - 2.00 (m), 1.71 (br. s), 1.52 (br. s), 1.34 - 1.14 (m), 1.01 - 0.74 (m), 0.65 - 0.47 (m).
GPC Mn = 8.30 kg/mol, Mw = 17.0 kg/mol, PDI = 2.00

### Application examples

The term "polymer 1" as used hereinafter refers to the polymer obtained by the above "polymerisation A".

The term "polymer 2" as used hereinafter refers to the polymer obtained by the above "polymerisation B".

For the photochemical and thermal solubility switch thin films of polymer 1 and 2 were produced on a glass substrate via spin-coating. The films were then irradiated at 365 nm for different time spans.

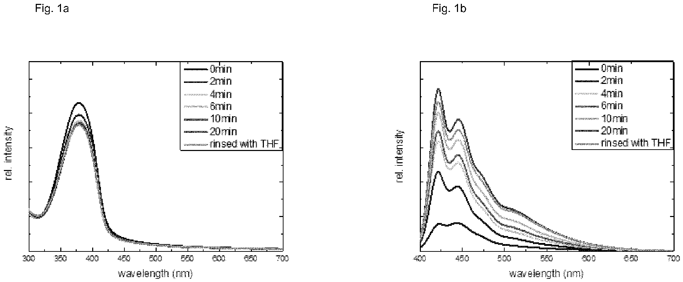

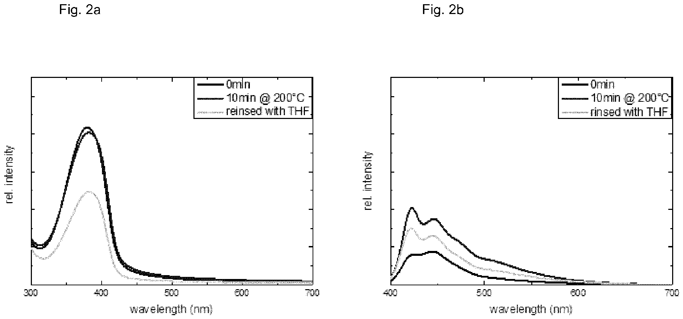

The progress of the cross-linking can be deduced from the reduction of the bands at 350-380 nm in the absorption spectrum shown in figure 1 a. In the case of polymer 1, the chromophore of the hydroxycinnamic acid and the absorption of the conjugated backbone of the polymer overlap. The reaction took place regardless of this overlap. The increase of the emission shown in figure 1b can be explained by the formation of coumarin, which is strongly emissive in this spectral range.
When the films were warmed to 200°C, an identical progress of the absorption and emission spectra could be observed, shown in figures 2a and 2b, which leads one to expect the reaction to progress identically.

When analyzing the rinsing solutions of the films, traces of the coumarin derivate could be detected.

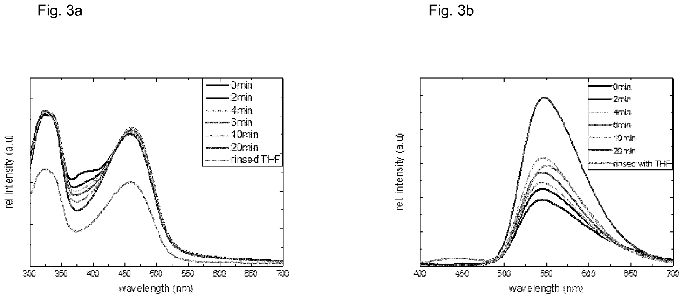

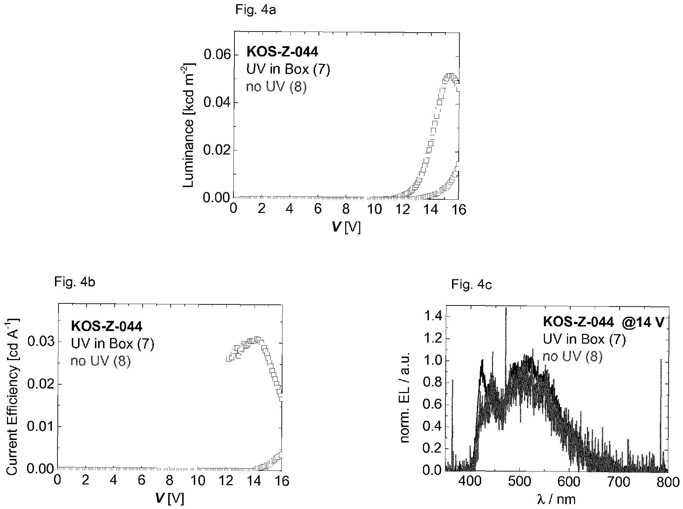

Polymer 2 could also successfully be directed in its solubility by irradiation at 365 nm. Figures 3a and 3b show the respective absorption and emission spectra.

After the rinsing step, a reduction of the layer thickness from 20 to 15 µm was detected in polymer 2. Analyses of the rinsing solution showed that only molecular weights smaller than 2 kg/mol were still soluble and that the coumarin derivative could again be detected in the rinsing solution.

The first OLED was built with polymer 1 as an emitter layer. Electroluminescence and charge transfer could be measured before and after the photoreaction. For the solubility switch the film was irradiated with an Ultra-LED at 365 nm for 10 min in the glove box.

### OLED components

OLED components were processed with the material KOS-Z-044 (K. Schelkle, Universität Heidelberg). For this the sequence glass/ITO/PEDOT:PSS/KOS-Z-044/Ca/Al was chosen. The solvent was chlorobenzene.

As can be seen in the figures below, functional OLEDs were produced which displayed a higher luminance and luminous efficacy after being irradiated with UV light. This is due to the high photoluminescent quantum yield of the dissociated coumarin unit, which constitutes a further interesting controlling mechanism for the emission characteristics of the OLED.

## Claims

1. A polymer of the formula (I) or (II), 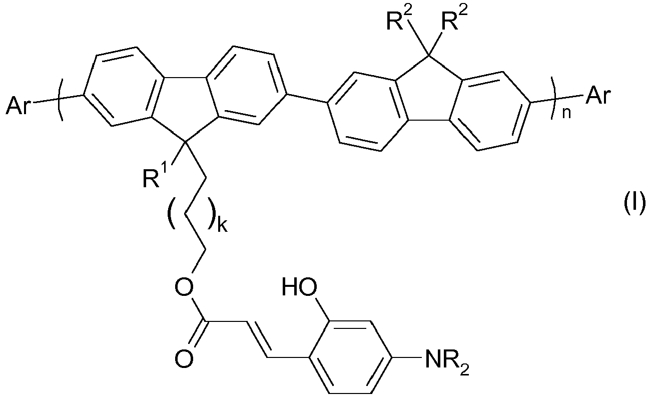 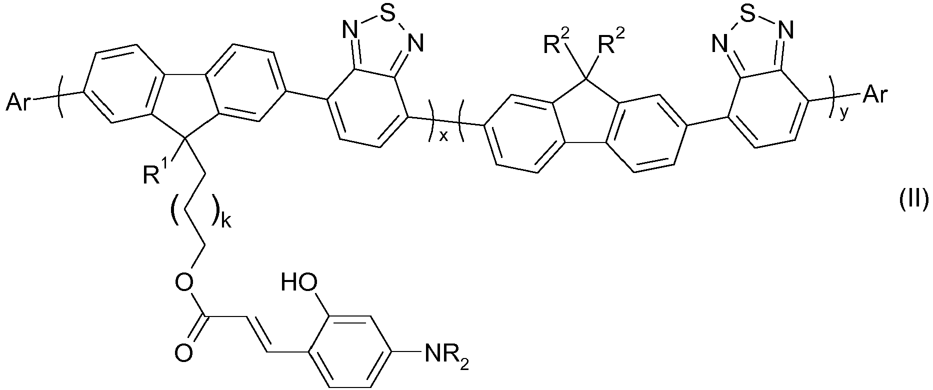 wherein
each R is independently a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl; or phenyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃;
R¹ is a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl;
each R² is independently a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl;
each Ar is independently phenyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃; biphenyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃; or naphthyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃;
k is an integer from 1 to 8;
n is an integer from 5 to 1000;
x is an integer from 3 to 500;
y is an integer from 3 to 500.

2. The polymer according to claim 1, wherein
each R is independently a linear or branched C₁-C₁₀-alkyl, which is unsubstituted;
R¹ is a linear or branched C₁-C₁₀-alkyl, which is unsubstituted;
each R² is independently a linear or branched C₁-C₁₀-alkyl, which is unsubstituted;
each Ar is independently phenyl, which is unsubstituted or substituted with 1 or 2 substituents selected from the group consisting of CN, NO₂, O(C₁-C₄-alkyl), N(C₁C₄-alkyl)₂, C₁-C₄-alkyl, and CF₃; unsubstituted biphenyl; or unsubstituted naphthyl;
k is an integer from 1 to 4;
n is an integer from 10 to 1000;
x is an integer from 5 to 500;
y is an integer from 5 to 500.

3. The polymer according to claim 1 or 2, wherein
each R is independently a linear or branched C₁-C₆-alkyl, which is unsubstituted;
R¹ is a linear or branched C₁-C₄-alkyl, which is unsubstituted;
each R² is independently a linear or branched C₅-C₁₀-alkyl, which is unsubstituted;
each Ar is independently phenyl, which is unsubstituted or substituted with 1 or 2 substituents selected from the group consisting of CN, O(C₁-C₄-alkyl), N(C₁-C₄-alkyl)₂, C₁-C₄-alkyl, and CF₃;
k is 1 or 2;
n is an integer from 10 to 600;
x is an integer from 5 to 300;
y is an integer from 5 to 300.

4. The polymer according to any one of claims 1 to 3, wherein the ratio of x to y is in the range of from 0.8 to 1.2.

5. The polymer according to any one of claims 1 to 3, wherein the polymer is a polymer of the formula (I).

6. The polymer according to any one of claims 1 to 4, wherein the polymer is a polymer of the formula (II).

7. A method for converting a polymer of the formula (I) or (II) according to any one of claims 1 to 6 into a polymer which is less soluble than the polymer of the formula (I) or (II), comprising the following steps:
(i) providing a polymer of the formula (I) or (II) according to any one of claims 1 to 6;
(ii) irradiating the polymer of step (i) with light of a wavelength in the range of from 320 to 420 nm or subjecting the polymer of step (i) to temperatures in the range of from 150 to 300 °C to obtain a polymer which is less soluble than the polymer of the formula (I) or (II).

8. The method according to claim 7, wherein the polymer in step (ii) is irradiated with light of a wavelength in the range of from 350 to 380 nm.

9. The method according to claim 7, wherein the polymer in step (ii) is subjected to temperatures in the range of from 180 to 220 °C.

10. The method according to any one of claims 7 to 9, further comprising the following step:
(iii) removing polymers which were not converted into less soluble polymers by rinsing with one or more solvents.

11. A polymer obtainable by the method of any one of claims 7 to 10.

12. A monomer of the formula (III), 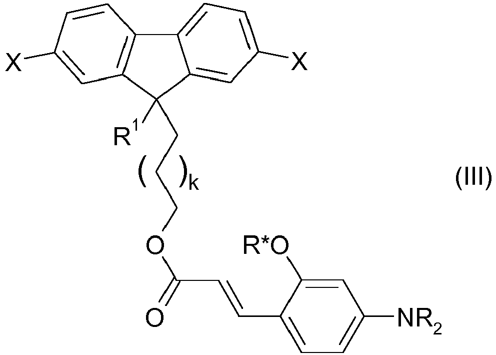 wherein
each X is independently halogen or OS(O)₂CF₃;
each R is independently a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl; or phenyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, C₁-C₄-alkyl, and CF₃;
R¹ is a linear or branched C₁-C₁₀-alkyl, which is unsubstituted or substituted with 1, 2 or 3 substituents selected from the group consisting of halogen, CN, NO₂, OH, O(C₁-C₄-alkyl), NH₂, NH(C₁-C₄-alkyl), N(C₁-C₄-alkyl)₂, and phenyl;
R* is H, tri(C₁-C₆-alkyl)silyl, or (C₁-C₆-alkyl)diphenylsilyl;
k is an integer from 1 to 8.

13. The monomer according to claim 12, wherein
each X is independently Br, I, or OS(O)₂CF₃;
each R is independently a linear or branched C₁-C₆-alkyl, which is unsubstituted;
R¹ is a linear or branched C₁-C₄-alkyl, which is unsubstituted;
R* is tri(C₁-C₆-alkyl)silyl;
k is 1 or 2.

14. An electronic device comprising the polymer of claim 11.

## Patentansprüche

1. Polymer der Formel (I) oder (II), 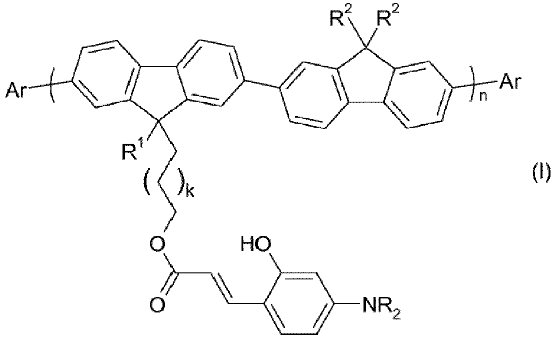 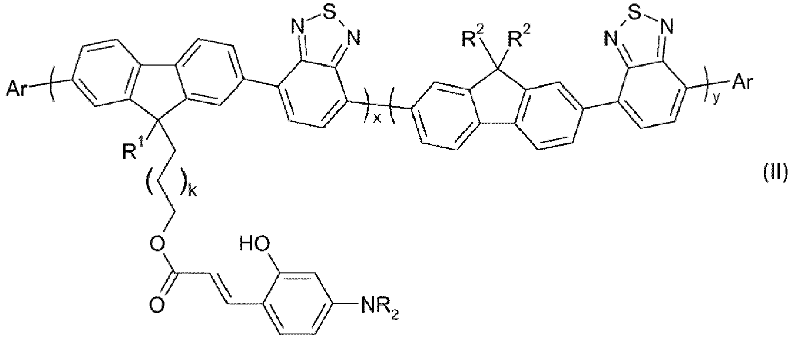 wobei
R jeweils unabhängig für ein lineares oder verzweigtes C₁-C₁₀-Alkyl, das unsubstituiert oder durch 1, 2 oder 3 Substituenten aus der Gruppe bestehend aus Halogen, CN, NO₂, OH, O(C₁-C₄-Alkyl), NH₂, NH(C₁-C₄-Alkyl), N(C₁-C₄-Alkyl)₂ und Phenyl substituiert ist; oder Phenyl, das unsubstituiert oder durch 1, 2 oder 3 Substituenten aus der Gruppe bestehend aus Halogen, CN, NO₂, OH, O(C₁-C₄-Alkyl), NH₂, NH(C₁-C₄-Alkyl), N(C₁-C₄-Alkyl)₂, C₁-C₄-Alkyl und CF₃ substituiert ist; steht;
R¹ für ein lineares oder verzweigtes C₁-C₁₀-Alkyl, das unsubstituiert oder durch 1, 2 oder 3 Substituenten aus der Gruppe bestehend aus Halogen, CN, NO_{2,} OH, O(C₁-C₄-Alkyl), NH₂, NH(C₁-C₄-Alkyl), N(C₁-C₄-Alkyl)₂ und Phenyl substituiert ist, steht;
R² jeweils für ein lineares oder verzweigtes C₁-C₁₀-Alkyl, das unsubstituiert oder durch 1, 2 oder 3 Substituenten aus der Gruppe bestehend aus Halogen, CN, NO_{2,} OH, O(C₁-C₄-Alkyl), NH₂, NH(C₁-C₄-Alkyl), N(C₁-C₄-Alkyl)₂ und Phenyl substituiert ist, steht;
Ar jeweils unabhängig für Phenyl, das unsubstituiert oder durch 1, 2 oder 3 Substituenten aus der Gruppe bestehend aus Halogen, CN, NO_{2,} OH, O(C₁-C₄-Alkyl), NH₂, NH(C₁-C₄-Alkyl), N(C₁-C₄-Alkyl)₂, C₁-C₄-Alkyl und CF₃ substituiert ist; Biphenyl, das unsubstituiert oder durch 1, 2 oder 3 Substituenten aus der Gruppe bestehend aus Halogen, CN, NO₂, OH, O(C₁-C₄-Alkyl), NH₂, NH(C₁-C₄-Alkyl), N(C₁-C₄-Alkyl)₂, C₁-C₄-Alkyl und CF₃ substituiert ist; oder Naphthyl, das unsubstituiert oder durch 1, 2 oder 3 Substituenten aus der Gruppe bestehend aus Halogen, CN, NO₂, OH, O(C₁-C₄-Alkyl), NH₂, NH(C₁-C₄-Alkyl), N(C₁-C₄-Alkyl)₂, C₁-C₄-Alkyl und CF₃ substituiert ist; steht;
k für eine ganze Zahl von 1 bis 8 steht;
n für eine ganze Zahl von 5 bis 1000 steht;
x für eine ganze Zahl von 3 bis 500 steht;
y für eine ganze Zahl von 3 bis 500 steht.

2. Polymer nach Anspruch 1, wobei
R jeweils unabhängig für ein lineares oder verzweigtes C₁-C₁₀-Alkyl, das unsubstituiert ist, steht;
R¹ für ein lineares oder verzweigtes C₁-C₁₀-Alkyl, das unsubstituiert ist, steht;
R² jeweils für ein lineares oder verzweigtes C₁-C₁₀-Alkyl, das unsubstituiert ist, steht;
Ar jeweils unabhängig für Phenyl, das unsubstituiert oder durch 1 oder 2 Substituenten aus der Gruppe bestehend aus CN, NO₂, O(C₁-C₄-Alkyl), N(C₁-C₄-Alkyl)₂, C₁-C₄-Alkyl und CF₃ substituiert ist; unsubstituiertes Biphenyl oder unsubstituiertes Naphthyl steht;
k für eine ganze Zahl von 1 bis 4 steht;
n für eine ganze Zahl von 10 bis 1000 steht;
x für eine ganze Zahl von 5 bis 500 steht;
y für eine ganze Zahl von 5 bis 500 steht.

3. Polymer nach Anspruch 1 oder 2, wobei
R jeweils unabhängig für ein lineares oder verzweigtes C₁-C₆-Alkyl, das unsubstituiert ist, steht;
R¹ für ein lineares oder verzweigtes C₁-C₄-Alkyl, das unsubstituiert ist, steht;
R² jeweils für ein lineares oder verzweigtes C₅-C₁₀-Alkyl, das unsubstituiert ist, steht;
Ar jeweils unabhängig für Phenyl, das unsubstituiert oder durch 1 oder 2 Substituenten aus der Gruppe bestehend aus CN, O(C₁-C₄-Alkyl), N(C₁-C₄-Alkyl)₂, C₁-C₄-Alkyl und CF₃ substituiert ist, steht;
k für 1 oder 2 steht;
n für eine ganze Zahl von 10 bis 600 steht;
x für eine ganze Zahl von 5 bis 300 steht;
y für eine ganze Zahl von 5 bis 300 steht.

4. Polymer nach einem der Ansprüche 1 bis 3, wobei das Verhältnis von x zu y im Bereich von 0,8 bis 1,2 liegt.

5. Polymer nach einem der Ansprüche 1 bis 3, wobei es sich bei dem Polymer um ein Polymer der Formel (I) handelt.

6. Polymer nach einem der Ansprüche 1 bis 4, wobei es sich bei dem Polymer um ein Polymer der Formel (II) handelt.

7. Verfahren zur Umwandlung eines Polymers der Formel (I) oder (II) nach einem der Ansprüche 1 bis 6 in ein Polymer, das weniger löslich ist als das Polymer der Formel (I) oder (II), bei dem man:
(i) ein Polymer der Formel (I) oder (II) nach einem der Ansprüche 1 bis 6 bereitstellt;
(ii) das Polymer von Schritt (i) mit Licht einer Wellenlänge im Bereich von 320 bis 420 nm bestrahlt oder das Polymer von Schritt (i) Temperaturen im Bereich von 150 bis 300 °C aussetzt, wobei man ein Polymer erhält, das weniger löslich ist als das Polymer der Formel (I) oder (II).

8. Verfahren nach Anspruch 7, bei dem man das Polymer in Schritt (ii) mit Licht einer Wellenlänge im Bereich von 350 bis 280 nm bestrahlt.

9. Verfahren nach Anspruch 7, bei dem man das Polymer in Schritt (ii) Temperaturen im Bereich von 180 bis 220 °C unterwirft.

10. Verfahren nach einem der Ansprüche 7 bis 9, bei dem man ferner:
(iii) nicht in weniger lösliche Polymere umgewandelte Polymere durch Spülen mit einem oder mehreren Lösungsmitteln entfernt.

11. Polymer, das durch das Verfahren nach einem der Ansprüche 7 bis 10 erhältlich ist.

12. Monomer der Formel (III), 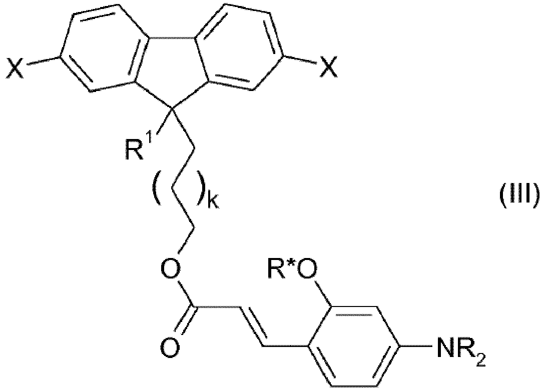 wobei
X jeweils unabhängig für Halogen oder OS(O)₂CF₃ steht;
R jeweils unabhängig für ein lineares oder verzweigtes C₁-C₁₀-Alkyl, das unsubstituiert oder durch 1, 2 oder 3 Substituenten aus der Gruppe bestehend aus Halogen, CN, NO_{2,} OH, O(C₁-C₄-Alkyl), NH₂, NH(C₁-C₄-Alkyl), N(C₁-C₄-Alkyl)₂ und Phenyl substituiert ist; oder Phenyl, das unsubstituiert oder durch 1, 2 oder 3 Substituenten aus der Gruppe bestehend aus Halogen, CN, NO₂, OH, O(C₁-C₄-Alkyl), NH₂, NH(C₁-C₄-Alkyl), N(C₁-C₄-Alkyl)₂, C₁-C₄-Alkyl und CF₃ substituiert ist; steht;
R¹ für ein lineares oder verzweigtes C₁-C₁₀-Alkyl, das unsubstituiert oder durch 1, 2 oder 3 Substituenten aus der Gruppe bestehend aus Halogen, CN, NO_{2,} OH, O(C₁-C₄-Alkyl), NH₂, NH(C₁-C₄-Alkyl), N(C₁-C₄-Alkyl)₂ und Phenyl substituiert ist, steht;
R* für H, Tri(C₁-C₆-alkyl)silyl oder (C₁-C₆-Alkyl)diphenylsilyl steht;
k für eine ganze Zahl von 1 bis 8 steht.

13. Monomer nach Anspruch 12, wobei
X jeweils unabhängig für Br, I oder OS(O)₂CF₃ steht;
R jeweils unabhängig für ein lineares oder verzweigtes C₁-C₆-Alkyl, das unsubstituiert ist, steht;
R¹ für ein lineares oder verzweigtes C₁-C₄-Alkyl, das unsubstituiert ist, steht;
R* für Tri(C₁-C₆-alkyl)silyl steht;
k für 1 oder 2 steht.

14. Elektronische Vorrichtung, umfassend das Polymer gemäß Anspruch 11.

## Revendications

1. Polymère de formule (I) ou (II), 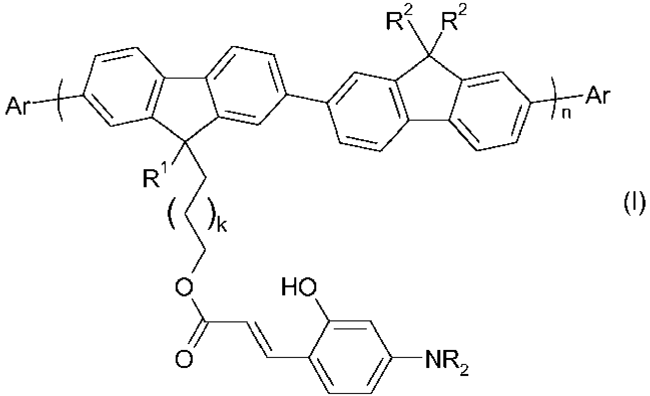 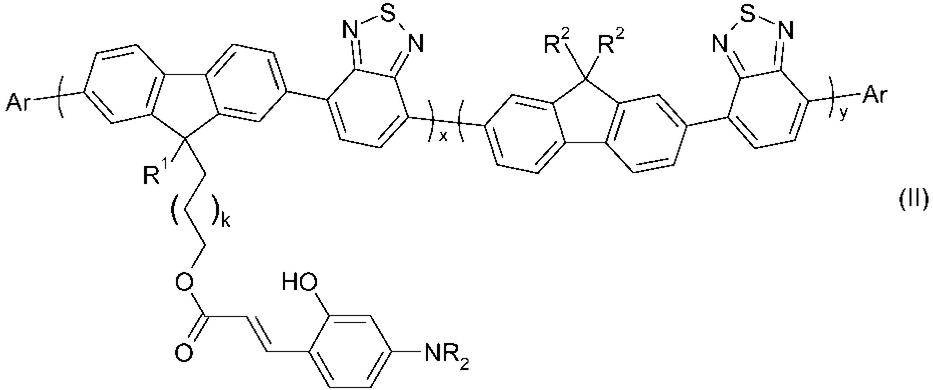 dans lequel
chaque R est indépendamment un alkyle en C₁-C₁₀ linéaire ou ramifié, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, et phényle ; ou
phényle, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, alkyle en C₁-C₄, et CF₃ ; R¹ est un alkyle en C₁-C₁₀ linéaire ou ramifié, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, et phényle ;
chaque R² est indépendamment un alkyle en C₁-C₁₀ linéaire ou ramifié, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, et phényle ;
chaque Ar est indépendamment phényle, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, alkyle en C₁-C₄, et CF₃ ; biphényle, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, alkyle en C₁-C₄, et CF₃ ; ou
naphtyle, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, alkyle en C₁-C₄, et CF₃ ;
k est un entier de 1 à 8 ;
n est un entier de 5 à 1000 ;
x est un entier de 3 à 500 ;
y est un entier de 3 à 500.

2. Polymère selon la revendication 1, dans lequel
chaque R est indépendamment un alkyle en C₁-C₁₀ linéaire ou ramifié, qui est non substitué ;
R¹ est un alkyle en C₁-C₁₀ linéaire ou ramifié, qui est non substitué ;
chaque R² est indépendamment un alkyle en C₁-C₁₀ linéaire ou ramifié, qui est non substitué ;
chaque Ar est indépendamment phényle, qui est non substitué ou substitué par 1 ou 2 substituants choisis dans le groupe constitué de CN, NO₂, O(alkyle en C₁-C₄), N(alkyle en C₁-C₄)₂, alkyle en C₁-C₄, et CF₃ ; biphényle non substitué ; ou naphtyle non substitué ;
k est un entier de 1 à 4 ;
n est un entier de 10 à 1000 ;
x est un entier de 5 à 500 ;
y est un entier de 5 à 500.

3. Polymère selon la revendication 1 ou 2, dans lequel
chaque R est indépendamment un alkyle en C₁-C₆ linéaire ou ramifié, qui est non substitué ; R¹ est un alkyle en C₁-C₄ linéaire ou ramifié, qui est non
substitué ; chaque R² est indépendamment un alkyle en C₅-C₁₀ linéaire ou ramifié, qui est non substitué ;
chaque Ar est indépendamment phényle, qui est non substitué ou substitué par 1 ou 2 substituants choisis dans le groupe constitué de CN, O(alkyle en C₁-C₄), N(alkyle en C₁-C₄)₂, alkyle en C₁-C₄, et CF₃ ;
k est 1 ou 2 ;
n est un entier de 10 à 600 ;
x est un entier de 5 à 300 ;
y est un entier de 5 à 300.

4. Polymère selon l'une quelconque des revendications 1 à 3, dans lequel le rapport de x à y est dans la plage de 0,8 à 1,2.

5. Polymère selon l'une quelconque des revendications 1 à 3, le polymère étant un polymère de formule (I) .

6. Polymère selon l'une quelconque des revendications 1 à 4, le polymère étant un polymère de formule (II).

7. Procédé de conversion d'un polymère de formule (I) ou (II) selon l'une quelconque des revendications 1 à 6 en polymère qui est moins soluble que le polymère de formule (I) ou (II), comprenant les étapes suivantes :
(i) fourniture d'un polymère de formule (I) ou (II) selon l'une quelconque des revendications 1 à 6 ;
(ii) irradiation du polymère de l'étape (i) avec une lumière d'une longueur d'onde dans la plage de 320 à 420 nm ou soumission du polymère de l'étape (i) à des températures dans la plage de 150 à 300 °C pour obtenir un polymère qui est moins soluble que le polymère de formule (I) ou (II).

8. Procédé selon la revendication 7, dans lequel le polymère dans l'étape (ii) est irradié avec une lumière d'une longueur d'onde dans la plage de 350 à 380 nm.

9. Procédé selon la revendication 7, dans lequel le polymère dans l'étape (ii) est soumis à des températures dans la plage de 180 à 220 °C.

10. Procédé selon l'une quelconque des revendications 7 à 9, comprenant en outre l'étape suivante :
(iii) élimination des polymères qui n'ont pas été convertis en polymères moins solubles par rinçage avec un ou plusieurs solvants.

11. Polymère pouvant être obtenu par le procédé de l'une quelconque des revendications 7 à 10.

12. Monomère de formule (III), 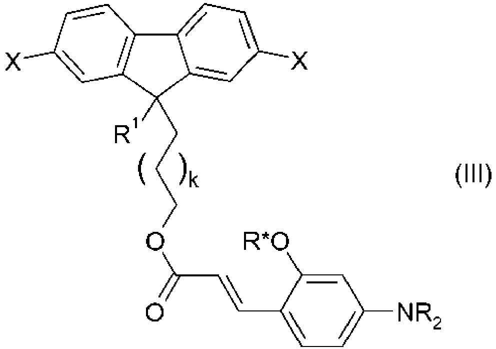 dans lequel
chaque X est indépendamment halogène ou OS(O)₂CF₃ ; chaque R est indépendamment un alkyle en C₁-C₁₀ linéaire ou ramifié, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, et phényle ; ou
phényle, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, alkyle en C₁-C₄, et CF₃ ;
R₁ est un alkyle en C₁-C₁₀ linéaire ou ramifié, qui est non substitué ou substitué par 1, 2 ou 3 substituants choisis dans le groupe constitué d'halogène, CN, NO₂, OH, O(alkyle en C₁-C₄), NH₂, NH(alkyle en C₁-C₄), N(alkyle en C₁-C₄)₂, et phényle ;
R* est H, tri (alkyle en C₁-C₆)silyle, ou (alkyle en C₁-C₆)diphénylsilyle ;
k est un entier de 1 à 8.

13. Monomère selon la revendication 12, dans lequel chaque X est indépendamment Br, I, ou OS(O)₂CF₃ ;
chaque R est indépendamment un alkyle en C₁-C₆ linéaire ou ramifié, qui est non substitué ;
R¹ est un alkyle en C₁-C₄ linéaire ou ramifié, qui est non substitué ;
R* est tri (alkyle en C₁-C₆)silyle ;
k est 1 ou 2.

14. Dispositif électrique comprenant le polymère de la revendication 11.
